# EUROPEAN PATENT APPLICATION

(11) **EP 3 629 085 A1**
(43) Date of publication of application: **01.04.2020**
(21) Application number: 18196447.9
(22) Date of filing: 25.09.2018
(51) Int. Cl.: G03F 7/20

(54) **METHOD AND APPARATUS FOR MEASURING PUPIL SHAPE**

(71) Applicant: ASML Netherlands B.V., 5500 AH Veldhoven (NL)
(72) Inventor: STOFFELS, Freerk Adriaan, 5500 AH Veldhoven (NL); HARTGERS, Albertus, 5500 AH Veldhoven (NL)
(74) Representative: Slenders, Petrus Johannes Waltherus

(57) **Abstract**

A method for determining at least a part of an angular intensity distribution of radiation at an object plane of an optical system, which may be referred to as an object level pupil shape, is disclosed. The method comprises directing the radiation onto a diffraction grating in the object plane so as to create at least one non-zeroth order diffraction beam which is at least partially received by the optical system; forming an image of a pupil plane of the optical system in a sensor plane and determining a spatial intensity distribution of radiation in the sensor plane; and determining at least a part of the angular intensity distribution of radiation at the object plane from the determined spatial intensity distribution of radiation in the sensor plane. The method is advantageous since it allows reconstruction of the angular intensity distribution of radiation at an object plane of an optical system, from a measurement at image plane level, even in situations where there is an obscuration of the pupil plane within the optical system.

## Description

### FIELD

The present invention relates to a method and apparatus for determining a pupil shape, i.e. the angular intensity distribution of radiation at a field plane of an optical system (for example a lithographic apparatus). In particular, the present invention is concerned with determining such a pupil shape in an object plane (for example at reticle level) from a measurement in an image plane (for example at wafer level). The present invention has particular application for optical systems that have an obscuration such as, for example, high numerical aperture EUV lithographic systems.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

There is a constant desire in the field of lithography to form images on substrates with smaller dimensions and it will be appreciated that generally the image of the patterning device that is formed on the substrate is diffraction limited. Under these circumstances image quality can be significantly dependent on the angular intensity distribution of radiation that illuminates the patterning device (also referred to as the pupil, pupil shape or illumination mode). It is therefore desirable to have accurate control over the angular intensity distribution of radiation and for this purpose it is desirable to be able to measure the angular intensity distribution of radiation (for example to confirm that a desired angular intensity distribution of radiation has been achieved).

It may be desirable to provide a method and apparatus for measuring an angular distribution of an illumination beam that addresses one or more problems present in prior art systems.

### SUMMARY

According to a first aspect of the present invention there is provided a method for determining at least a part of an angular intensity distribution of radiation at an object plane of an optical system, the method comprising: directing the radiation onto a diffraction grating in the object plane so as to create at least one non-zeroth order diffraction beam which is at least partially received by the optical system; forming an image of a pupil plane of the optical system in a sensor plane and determining a spatial intensity distribution of radiation in the sensor plane; and determining at least a part of the angular intensity distribution of radiation at the object plane from the determined spatial intensity distribution of radiation in the sensor plane.

The method according to the first aspect of the invention is advantageous since it allows reconstruction of the angular intensity distribution of radiation at an object plane of an optical system, from a measurement at image plane level, even in situations where there is an obscuration of the pupil plane within the optical system, as now discussed.

The optical system may comprise the projection system of a lithographic apparatus. Such an apparatus can be used to form an image of a patterning device (also known as a reticle) on a substrate (for example a resist covered silicon wafer). It will be appreciated that for such embodiments, the object plane may coincide with a plane in which the patterning device is disposed and the image plane may coincide with a plane in which the substrate is disposed. The object plane of the projection system, the image plane of the projection system and any planes conjugate thereto may be referred to as field planes of the lithographic apparatus.

There is a constant desire in the field of lithography to form images with smaller dimensions and it will be appreciated that generally the image of the patterning device that is formed on the substrate is diffraction limited. Under these circumstances image quality can be significantly dependent on the angular intensity distribution of radiation that illuminates the patterning device. It is therefore desirable to have accurate control over the angular intensity distribution of radiation and for this purpose it is desirable to be able to measure the angular intensity distribution of radiation (for example to confirm that a desired angular intensity distribution of radiation has been achieved).

The intensity (or, equivalently, the electric field strength) distribution of radiation in the illumination pupil plane (also known as the pupil or pupil shape) characterizes the angular distribution of the light cone at the reticle level (i.e. in the object plane).

Typically, the projection system of a lithographic apparatus has an optical transfer function which may be non-uniform, which can affect the pattern which is imaged on the substrate. For unpolarized radiation such effects can be fairly well described by two scalar maps, which describe the transmission (apodization) and relative phase (aberration) of radiation exiting the projection system as a function of position in a pupil plane thereof. Typically, it is also desirable to determine such aberrations and transmission variations. Advantageously, the method according to the first aspect of the invention avoids having to use two separate sensors (one in the object plane and one in the image plane) by allowing the angular intensity distribution of radiation at the object level of an optical system to be determined from a measurement at image plane level.

Furthermore, the method according to the first aspect of the invention allows parts of the pupil at object plane level to be determined even in situations where there is an obscuration of the pupil plane within the optical system. This is because when the radiation is directed onto the diffraction grating in the object plane and one or more order diffraction beams are created, in the pupil plane of the projection system, these diffraction beams will be copies of the pupil with which the grating was illuminated. It will be appreciated that, for each non-zeroth order diffraction beam, each such copy will be shifted in the pupil plane relative to the zeroth order diffraction beam (which corresponds to the pupil with which the grating was illuminated). The amount by which these non-zeroth order diffraction beams are shifted is dependent on the pitch of the diffraction grating and the wavelength of the radiation. It will be appreciated that, in general, each non-zeroth order diffraction beam will be shifted by a different amount relative to the zeroth order diffraction beam in the pupil plane. In particular, in pupil plane coordinates that are normalized to the numerical aperture of the optical system, the shift of each non-zeroth order diffraction beam from the zeroth order diffraction beam in the pupil plane is given by (n·λ)/(p·NA), where n is the diffraction order, λ is the wavelength of the radiation, p is the pitch of the diffraction grating and NA is the numerical aperture of the optical system. It will be further appreciated that each such copy will be weighted by a grating efficiency for that diffraction order (which, in turn, is dependent on the geometry of the grating).

The method according to the present invention therefore produces shifted copies of the object level pupil in the pupil plane of the projection system. This can allow parts of the object level pupil which correspond to an obscuration of the projection system pupil plane to be shifted to a region of the projection system pupil plane which does not overlap with the obscuration. As a result, these parts of the object level pupil can be measured at image level.

The method may further comprise: directing the radiation onto an object that samples at least a part of the radiation such that at least that part of the radiation is received by the optical system with substantially the same angular distribution; forming an image of a pupil plane of the optical system in a sensor plane and determining a spatial intensity distribution of radiation in the sensor plane; and determining at least a part of the angular intensity distribution of radiation at the object plane from the determined spatial intensity distribution of radiation in the sensor plane.

For such embodiments, the step of directing the radiation onto an object that samples at least a part of the radiation such that at least that part of the radiation is received by the optical system with substantially the same angular distribution can be used to determine parts of the object level pupil that do not correspond to an obscuration within the optical system. It will be appreciated that, separately, the step of directing the radiation onto a diffraction grating in the object plane so as to create at least one non-zeroth order diffraction beam which is at least partially received by the optical system can be used to determine parts of the object level pupil that do correspond to an obscuration within the optical system.

It will be appreciated that for reflective systems, an object that samples at least a part of the radiation such at least that part of the radiation is received by the optical system with substantially the same angular distribution comprises a mirror that is arranged to provide specular reflection. It will be appreciated that for transmissive systems, an object that samples at least a part of the radiation such at least that part of the radiation is received by the optical system with substantially the same angular distribution comprises a transmissive portion that is arranged to transmit the radiation.

When the radiation is directed onto the diffraction grating in the object plane so as to create at least one non-zeroth order diffraction beam which is at least partially received by the optical system it may be that only a part of the angular distribution to be measured is used.

The only a part of the angular distribution to be measured may substantially correspond to a part of a pupil plane of the optical system that is obscured by the optical system.

It will be appreciated that as used here, a part of the angular distribution substantially corresponding to a part of a pupil plane of the optical system that is obscured by the optical system may include that part of a pupil plane of the optical system that is obscured by the optical system and may optionally also include a bit more of the pupil plane.

The pitch of the grating may be such that an angular separation of adjacent diffraction beams is greater than half an angular extent of an obscuration of the optical system.

Advantageously, with such an arrangement first order diffraction beams generated by the diffraction grating will shift the region of the object level pupil such that at least half of them no longer overlap with the obscuration of the optical system. The ±1^{st} order diffraction beams will each be shifted in opposite directions (by at least half of the extent of the obscuration of the optical system), potentially allowing both halves of the region of the object level pupil that corresponds to the obscuration of the optical system to be determined (from the ±1^{st} order diffraction beams respectively).

The pitch of the grating may be such that an angular separation of adjacent diffraction beams is greater than an angular extent of the radiation that is directed onto the diffraction grating in the object plane.

Advantageously, with such an arrangement adjacent order diffraction beams generated by the diffraction grating will not overlap in the pupil plane of the optical system.

Determining at least a part of the angular intensity distribution of radiation at the object plane from the determined spatial intensity distribution of radiation in the sensor plane may comprise: associating at least one region of the spatial intensity distribution of radiation in the sensor plane with a weighted sum of a plurality of regions in an object level pupil plane, the weights of said weighted sum of pixels being dependent on grating efficiencies of the grating.

For example, in one embodiment, when the radiation is directed onto the diffraction grating in the object plane so as to create at least one non-zeroth order diffraction beam which is at least partially received by the optical system substantially the entire angular distribution to be measured may be used. The grating may create a plurality of copies of the object level pupil, the copies being shifted relative to each other in a shearing direction of the grating. These diffraction beams may partially overlap. Therefore, at least some pixels in the sensor plane may receive contributions from a plurality of different diffraction beams (and, therefore, from a plurality of different parts of the object level pupil weighted by the corresponding grating efficiencies). It will be appreciated that this weighted sum may be an incoherent (intensity level) sum.

The pitch of the grating may be such that an angular separation of adjacent diffraction beams is greater than half an angular extent of an obscuration of the optical system.

Forming the image of the pupil plane of the optical system in the sensor plane and determining a spatial intensity distribution of radiation in the sensor plane may comprise: projecting the radiation onto a membrane having an aperture, the membrane being disposed in an image plane of the optical system; and determining a spatial intensity distribution of radiation in a sensor plane on an opposite side of the membrane to the optical system.

That is, the image formation is achieved in a similar manner to a pinhole camera. The aperture may be circular and may have a diameter of the order of 50 µm.

The diffraction grating may be provided on a region in the object plane that is surrounded by a radiation blocking region that substantially blocks radiation received by it from entering the optical system.

That is, the diffraction grating may be provided on a pinhole (either reflective or transmissive). The pinhole may be circular and may have a diameter of the order of 50 µm. Advantageously, this allows the pupil at a particular field point (in the object plane) to be sampled. This may be advantageous since the pupil may be field dependent (in particular towards the edge of the field).

The object that samples at least a part of the radiation such at least that part of the radiation is received by the optical system with substantially the same angular distribution may be provided on a region in the object plane that is surrounded by a radiation blocking region that substantially blocks radiation received by it from entering the optical system.

The diffraction grating may be arranged to suppress the zeroth order diffraction beam.

It will be appreciated that such suppression of the zeroth order diffraction beam may be achieved using phase-shift mask techniques. For example, the diffraction grating may be of the form of an alternating phase-shift mask that is arranged such that alternate light transmitting portions (either transmissive or reflective) result in a 180° phase change for the zeroth order diffraction beam but not for non-zeroth order diffraction beams.

Advantageously, this results in no zeroth order diffraction beam that may overlap with the non-zeroth order diffraction beams (for example the first order diffraction beams).

The pitch of the grating may be such that only the first order diffraction beams are at least partially received by the optical system.

The pitch of the grating may be such that second order diffraction beams and higher order diffraction beams are not received by the optical system.

According to a second aspect of the present invention there is provided an apparatus comprising: an object support for supporting a patterning device in an object plane; an image support for supporting a substrate in an image plane; an illumination system operable to produce a radiation beam and irradiate the patterning device in the object plane so as to form a patterned radiation beam; a projection system operable to receive the patterned radiation beam and to form an image of the patterning device in the image plane; and a sensor, the sensor being operable to form an image of a pupil plane of the projection system in a sensor plane to and determine a spatial intensity distribution of radiation in the sensor plane; and a processor operable to determine at least a part of the angular intensity distribution of the radiation beam at the object plane from the determined spatial intensity distribution of radiation in the sensor plane; wherein the projection system has an obscuration such that an intensity of the patterned radiation beam in a part of the pupil plane of the projection system is substantially zero; and wherein the at least a part of the angular intensity distribution of the radiation beam that the processor is operable to determine includes a part of the angular intensity distribution of the radiation beam that corresponds to the obscuration of the projection system.

The apparatus according to the second aspect of the invention is operable to carry out the method according to the first aspect of the invention. The apparatus according to the second aspect of the invention may comprise a lithographic apparatus.

It will be appreciated that the patterning device may comprise a diffraction grating arranged to create at least one non-zeroth order diffraction beam which is at least partially received by the projection system.

The sensor may be disposed on the image support. Alternatively, the sensor may be disposed on a separate component such as a fiducial. Such a fiducial may be supported by the image support or, alternatively the fiducial and the image support may both ne supported by a common supporting member.

The apparatus according to the second aspect of the invention may be configured to perform the method of the first aspect of the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 is a schematic representation of a diffraction grating that may be provided on the support structure of the lithographic system shown in Figure 1 and used as part of a method for determining at least a part of an angular intensity distribution of radiation at an object plane of the lithographic system;
- Figure 3A is a schematic cross-sectional representation of a sensor that may be provided on the substrate table of the lithographic system shown in Figure 1 and used as part of a method for determining at least a part of an angular intensity distribution of radiation at an object plane of the lithographic system;

- Figure 3B is a schematic top view of a membrane having an aperture that forms part of the sensor shown in Figure 3A;
- Figure 4 is a schematic illustration of a conventional illumination mode in an illumination system pupil plane of the lithographic system shown in Figure 1 that it may be desired to measure;
- Figure 5 is a schematic representation of the projection system pupil plane for a lithographic apparatus projection system having a central obscuration;
- Figure 6 is a schematic representation of the intensity of radiation in the projection system pupil plane of Figure 5 when a diffraction grating of the type shown in Figure 2 is illuminated by the illumination mode shown in Figure 4;
- Figure 7 is a schematic representation of an object that may be provided on the support structure of the lithographic system shown in Figure 1 and which samples at least a part of radiation received from an illumination system of the lithographic apparatus such at least that part of the radiation is received by the projection system of the lithographic apparatus with substantially the same angular distribution;
- Figure 8 is a schematic representation of the intensity of radiation in the projection system pupil plane of Figure 5 when the object shown in Figure 7 is illuminated by the illumination mode shown in Figure 4;
- Figure 9 is a schematic illustration of a modified illumination mode in an illumination system pupil plane of the lithographic system shown in Figure 1, the modified illumination mode comprising a portion of the illumination mode shown in Figure 4; and
- Figure 10 is a schematic representation of the intensity of radiation in the projection system pupil plane of Figure 5 when a diffraction grating of the type shown in Figure 2 is illuminated by the modified illumination mode shown in Figure 9.

### DETAILED DESCRIPTION

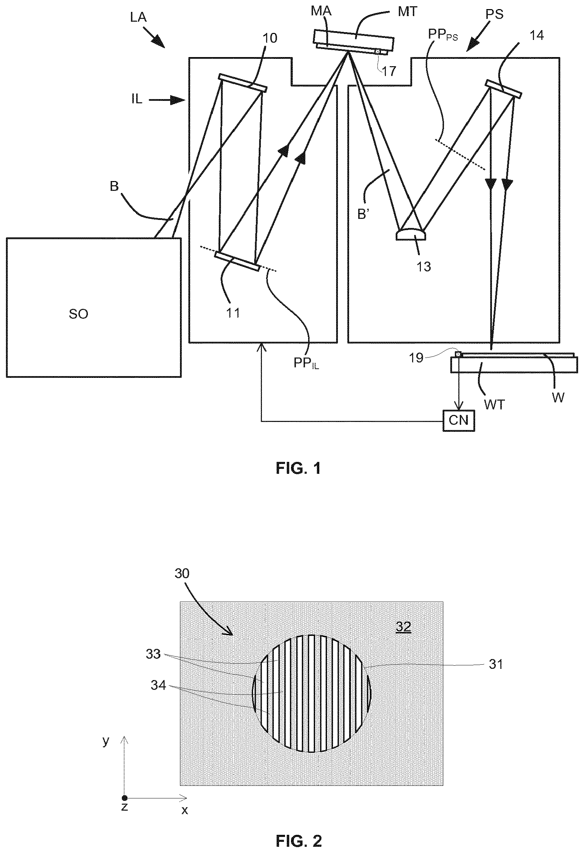

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W. The support structure MT may be referred to as an object support and the substrate table WT may be referred to as an image support.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The lithographic apparatus may, for example, be used in a scan mode, wherein the support structure (e.g. mask table) MT and the substrate table WT are scanned synchronously while a pattern imparted to the radiation beam is projected onto a substrate W (i.e. a dynamic exposure). The velocity and direction of the substrate table WT relative to the support structure (e.g. mask table) MT may be determined by the demagnification and image reversal characteristics of the projection system PS. The patterned radiation beam that is incident upon the substrate W may comprise a band of radiation. The band of radiation may be referred to as an exposure slit. During a scanning exposure, the movement of the substrate table WT and the support structure MT may be such that the exposure slit travels over an exposure field of the substrate W.

As has been described above, a lithographic apparatus may be used to expose portions of a substrate W in order to form a pattern in the substrate W. In order to improve the accuracy with which a desired pattern is transferred to a substrate W one or more properties of the lithographic apparatus LA may be measured. Such properties may be measured on a regular basis, for example before and/or after exposure of each substrate W, or may be measured more infrequently, for example, as part of a calibration process. Examples of properties of the lithographic apparatus LA which may be measured include a relative alignment of components of the lithographic apparatus LA and/or an aberration of components of the lithographic apparatus. For example, measurements may be made in order to determine the relative alignment of the support structure MT for supporting a patterning device MA and the substrate table WT for supporting a substrate W. Determining the relative alignment of the support structure MT and the substrate table WT assists in projecting a patterned radiation beam onto a desired portion of a substrate W. This may be particularly important when projecting patterned radiation onto a substrate W which includes portions which have already been exposed to radiation, so as to improve alignment of the patterned radiation with the previously exposed regions.

Additionally or alternatively measurements may be made in order to determine optical aberrations of the projection system PS. An optical aberration is a departure of the performance of an optical system from paraxial optics and may result in blurring or distortion of the pattern which is exposed at the substrate W. Aberrations of the projection system PS may be adjusted for and/or accounted for so as to increase the accuracy with which a desired pattern is formed on a substrate W.

The projection system PS may be considered to be, or to form part of, an optical system for forming an image of the patterning device MA on the substrate W. The pattering device MA may be considered to be disposed in an object plane of the projection system PS and the substrate W may be considered to be disposed in an image plane of the projection system PS. In the context of such a lithographic apparatus, the object plane of the projection system PS (where the patterning device MA is disposed), the image plane of the projection system PS (where the substrate W is disposed) and any planes conjugate thereto may be referred to as field planes of the lithographic apparatus. It will be appreciated that within an optical system (e.g. a lithographic apparatus) two planes are conjugate if each point within the first plane P is imaged onto a point in the second plane P'.

It will be appreciated that the lithographic apparatus LA comprises optics with optical power (i.e. focusing and/or diverging optics) in order to form an image in the image plane of an object in the object plane. Within such an optical system, between each pair of field planes it is possible to define a pupil plane which is a Fourier transform plane of a preceding field plane and a successive field plane. The distribution of the Electric field within each such pupil plane is related to a Fourier transform of an object disposed in a preceding field plane. It will be appreciated that the quality of such a pupil plane will depend on the optical design of the system and that such a pupil plane may even be curved.

It will also be appreciated that there may be more than one pupil plane disposed in the optical path between the object plane and the image plane. For example, in some embodiments, the projection system may comprise one or more intermediate field planes between the object plane and the image plane and there will be a pupil plane between each pair of field planes.

It is useful to consider two pupil planes: an illumination system pupil plane PP_{IL} and a projection system pupil plane PP_{PS}. The illumination system pupil plane and the projection system pupil plane (and any other pupil planes) are mutually conjugate planes. The projection system pupil plane PP_{PS} may be referred to as the exit pupil of the projection system PS of the lithographic apparatus LA. This is the image of a physical stop or aperture (located within the projection system PL) on the image side of the projection system PL (i.e. the wafer side). Similarly, the illuminator pupil plane PP_{IL} may be referred to as the exit pupil of the illuminator IL.

The illumination system pupil plane PP_{IL} and the projection system pupil plane PP_{PS} are shown schematically in Figure 1. Note that the illumination system pupil plane PP_{IL} coincides with the facetted pupil mirror device 11.

Note that each point in a field plane maps onto the entire successive pupil plane and vice versa. In particular, each field point (in either the object plane or the image plane) receives radiation at a range of angles. Each angle corresponds to a different point in the pupil plane. Therefore, a plurality of parallel rays of radiation at a field plane map onto a single point in a successive (or preceding) pupil plane.

Note that although each point in the projection system pupil plane PP_{PS} is conjugate to a point in the illuminator pupil plane PP_{IL}, diffraction from an object in the object plane will, in general, cause radiation from a given point in the illuminator pupil plane PP_{IL} to map into a plurality of points in the projection system pupil plane PP_{PS}. The zeroth order diffraction beam for a given point in the illuminator pupil plane PP_{IL} will be imaged onto a conjugate point in the projection system pupil plane PP_{PS}. Higher order diffraction beams will be imaged onto different parts of the projection system pupil plane PP_{PS} or may fall outside of the numerical aperture of the projection system PS such that they do not contribute to the image formed in the image plane.

The intensity (or, equivalently, the electric field strength) distribution of radiation in the illuminator pupil plane PP_{IL} may be referred to as the illumination mode, pupil fill, pupil shape or pupil and characterizes the angular distribution of the light cone at the reticle level (i.e. in the object plane). Similarly, the intensity (or, equivalently, the electric field strength) distribution of radiation in the projection system pupil plane PP_{PS} characterizes the angular distribution of the light cone at the wafer level (i.e. in the image plane).

As explained above, the illuminator IL may alter the intensity distribution of the beam in the illuminator pupil plane PP_{IL}. The illuminator may be arranged to limit the radial extent of the radiation beam such that the intensity distribution is non-zero within an annular region in the illuminator pupil plane PP_{IL}. Additionally or alternatively, the illuminator IL may also be operable to limit the distribution of the beam in the illuminator pupil plane PP_{IL} such that the intensity distribution is non-zero in a plurality of equally spaced sectors in the illuminator pupil plane PP_{IL}. The intensity distribution of the radiation beam in a pupil plane of the illuminator IL may be referred to as an illumination mode.

The illuminator IL is operable to control the spatial and the angular distribution of the radiation in the object plane. This is achieved via the facetted field mirror device 10 and the facetted pupil mirror device 11, each of which comprises a plurality of independently movable mirror elements. Generally, at least the outer and/or inner radial extent (commonly referred to as σ-outer and σ-inner, respectively) of the intensity distribution in the illuminator pupil plane PP_{IL} can be adjusted. By convention, the radial coordinate σ of a point in the illuminator pupil plane PP_{IL} or the projection system pupil plane PP_{PS} is typically normalised by the numerical aperture NA of the projections system PS (such that a circle of radius σ=1 corresponds to the region of the pupil plane which can physically be captured by the projection system PL and imaged onto the image plane IP). The illuminator IL may also be operable to vary the number, and angular extent, of sectors in the illuminator pupil plane PP_{IL} wherein the intensity distribution is non-zero. By adjusting the intensity distribution of the beam in illuminator pupil plane PP_{IL} of the illuminator IL, different illumination modes may be achieved.

During exposure of a substrate W the illumination system IL and the projection system PS are used to form an image of an object level patterning device MA on an image level substrate W (e.g. a resist coated silicon wafer). There is a constant desire in the field of lithography to form images with smaller dimensions and it will be appreciated that generally the image of the patterning device MA that is formed on the substrate W is diffraction limited. Under these circumstances image quality can be significantly dependent on the angular intensity distribution of radiation that illuminates the patterning device MA. During such an exposure, it may be desirable for the illumination mode to use a localized illumination mode. For example, it may be desirable to use a multipole (e.g. dipole or quadrupole) illumination mode, wherein in the pupil plane of the illumination system only a finite number (e.g. two or four) of discrete pole regions receive radiation. It is therefore desirable to have accurate control over the angular intensity distribution of radiation and for this purpose it is desirable to be able to measure the angular intensity distribution of radiation (for example to confirm that a desired angular intensity distribution of radiation has been achieved).

Furthermore, as explained above, even for optical systems that have an obscuration at image level (for example in a projection system pupil plane PP_{PS}) a conjugate portion of the pupil at object level can contribute to imaging due to diffraction at the patterning device MA. It is therefore useful to determine the entire pupil at object level (including those parts that are conjugate to the obscuration).

Embodiments of the present invention relate to new methods and apparatus for determining the angular intensity distribution of radiation at an object plane of an optical system (for example the plane of the patterning device MA in lithographic apparatus LA). In particular, these methods and apparatus allow this determination via a measurement at image plane level (i.e. in the plane of the substrate W), even in situations where there is an obscuration of the pupil plane within the optical system (i.e. in the projection system pupil plane PP_{PS}), as now discussed.

Embodiments of the present invention use a diffraction grating 17 disposed in the object plane. The diffraction grating 17 is of the form of a reflective marker 17 (as schematically shown in Figure 1) with radiation.

In the embodiment which is shown in Figure 1, the reflective marker 17 forms part of a patterning device MA. One or more markers 17 may be provided on patterning devices MA used to perform lithographic exposures. A marker 17 may be positioned outside of a patterned region of the patterning device MA, which is illuminated with radiation during a lithographic exposure but may be moved into the path of the radiation during a measurement of the angular distribution of radiation at the object plane. In some embodiments, one or more markers 17 may additionally or alternatively be provided on, and supported by, the support structure MT. For example, a dedicated piece of hardware, often referred to as a fiducial, may be provided on the support structure MT. A fiducial may include one or more markers. For the purposes of this description a fiducial is considered to be an example of a patterning device. In some embodiments, a patterning device MA specifically designed for measuring one or more properties of the lithographic apparatus LA may be placed on the support structure MT in order to perform a measurement process. The patterning device MA may include one or more markers 17 for illumination as part of a measurement process.

An embodiment 30 of the diffraction grating 17 is shown in Figure 2. In this embodiment, the diffraction grating 30 is provided on a circular region 31 in the object plane that is surrounded by a radiation blocking region 32 that substantially blocks radiation received by it from entering the projection system PS. Within the circular region 31, the diffraction grating comprises alternating reflective portions 33 and radiation absorbing portions 34 (which may be formed from the same material as radiation blocking region 32). That is, the diffraction grating 30 is provided on a reflective pinhole. The pinhole is circular and may have a diameter of the order of 50 µm. Advantageously, this allows the pupil at a particular field point (in the object plane) to be sampled. This may be advantageous since the pupil may be field dependent (in particular towards the edge of the field).

It will be appreciated that such a reflective marker may be formed from a reflective substrate (for example a multi-layer stack or Bragg mirror) which provides the radiation reflecting portions. The radiation absorbing portions are formed by a depositing a radiation absorbing material onto the underlying reflective substrate.

Embodiments of the present invention also use a sensor 19 (as shown schematically in Figure 1) on the substrate table WT, which is operable to form an image of the projection system pupil plane PP_{PS} in a sensor plane to and determine a spatial intensity distribution of radiation in that sensor plane. The sensor apparatus 19 may, for example, be provided on the substrate table WT as shown in Figure 1.

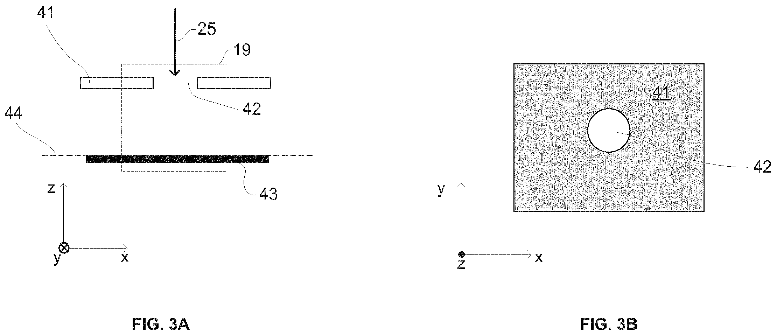

An embodiment 40 of the sensor 19 is shown in Figures 3A and 3B.

The sensor 40 shown in Figures 3A and 3B comprises a membrane 41 having an aperture 42, the membrane 42 being disposed in an image plane of the projection system PS. The sensor further comprises a radiation sensor 43 disposed in a sensor plane 44 on an opposite side of the membrane 41 to the projection system PS. At least some of the radiation 25 which is output from the projection system PS passes through the aperture 42 and is incident on the radiation sensor 43 so as to form the image of the projection system pupil plane PP_{PS}. That is, the image formation is achieved in a similar manner to a pinhole camera. The aperture 42 may be circular and may have a diameter of the order of 50 µm.

The radiation sensor 43 is operable to determine a spatial intensity distribution of radiation which is incident on the radiation detector 43 in the sensor plane 44. The radiation detector 43 may, for example, comprise an array of individual detector elements. For example, the radiation detector 43 may comprise a CCD or CMOS array.

During a method for determining at least a part of an angular intensity distribution of radiation at the object plane of the projection system PS, the support structure MT may be positioned such that the marker 17 is illuminated with radiation from the illumination system IL. The substrate table WT may be positioned such that radiation reflected from the marker is projected by the projection system PS onto the sensor apparatus 19.

In order to perform a measurement process, the support structure MT may be positioned such that the marker 17 on the patterning device MA is illuminated with radiation. The substrate table WT may be positioned such that radiation which is reflected from the marker 17 is projected, by the projection system PS, onto the sensor apparatus 19. The sensor apparatus 19 is in communication with a controller CN. The controller CN comprises a processor that is operable to determine at least a part of the angular intensity distribution of the radiation beam at the object plane from the determined spatial intensity distribution of radiation 25 in the sensor plane 44.

In some embodiments a plurality of markers 17 and/or sensor apparatuses 19 may be provided and properties of the lithographic apparatus LA may be measured at a plurality of different field points (i.e. locations in a field or object plane of the projection system PS).

The controller CN may be further configured to control one or more components of the illumination system IL of the lithographic apparatus LA. For example, the controller CN may control a configuration of the facetted field mirror device 10 and/or the facetted pupil mirror device 11 so as to achieve a desired illumination mode.

Typically, the projection system PS of a lithographic apparatus LA has an optical transfer function which may be non-uniform, which can affect the pattern which is imaged on the substrate W. For unpolarized radiation such effects can be fairly well described by two scalar maps, which describe the transmission (apodization) and relative phase (aberration) of radiation exiting the projection system PS as a function of position in a pupil plane thereof. Typically, it is desirable to determine such aberrations and transmission variations in addition to determining the angular distribution of radiation at reticle level. Advantageously, the sensor apparatus 19 can also be used for such measurements since it is disposed at wafer level on the substrate table WT. For example, for aberration measurements the membrane 41 with the aperture 42 can be replaced by a membrane that is of the form of a transmissive diffraction grating (for example of the form of a checkerboard). This avoids having to use two separate sensors (one in the object plane and one in the image plane) by allowing the angular intensity distribution of radiation at the object level of an optical system to be determined from a measurement at image plane level.

The apparatus and methods according to embodiments of the present invention are particularly suitable for measuring the pupil at object plane level in situations where there is an obscuration of the projection system pupil plane PP_{PS}. This is because when the radiation is projected onto the diffraction grating 17 in the object plane one or more order diffraction beams are created. In the projection system pupil plane PP_{PS}, these diffraction beams will be copies of the illumination system pupil plane PP_{IL} with which the grating 17 was illuminated. It will be appreciated that, for each non-zeroth order diffraction beam, each such copy will be shifted in the pupil plane projection system pupil plane PP_{PS} relative to the zeroth order diffraction beam (which corresponds to the pupil with which the grating 17 was illuminated). The amount by which these non-zeroth order diffraction beams are shifted is dependent on the pitch of the diffraction grating 17 and the wavelength of the radiation. It will be further appreciated that each such copy will be weighted by a grating efficiency for that diffraction order (which, in turn, is dependent on the geometry of the grating 17).

Methods according to embodiments of the present invention produce shifted copies of the illumination system pupil plane PP_{IL} in the projection system pupil plane PP_{PS}. This can allow parts of the illumination system pupil plane PP_{IL} which correspond to an obscuration of the projection system pupil plane PP_{PS} to be shifted to a region of the projection system pupil plane PP_{PS} which does not overlap with the obscuration. As a result, these parts of the object level pupil can be measured at image level.

The projection system PS may have, for example, a central obscuration in the projection system pupil plane PP_{PS}. That is, there may be an absence of radiation in a central portion of the cone of radiation that is projected onto the substrate W. Such a situation may occur in high numerical aperture EUV lithographic systems. In such a high numerical aperture EUV lithographic systems, the last mirror in the projection system PS (which is typically a concave, near-normal-incidence multi-layer stack mirror) of such a system is typically large and disposed above the substrate W. In order to deliver radiation to this mirror, typically the radiation must be delivered through a central aperture in this last mirror and reflected from a penultimate mirror that generally fills the last mirror with EUV radiation. The presence of the central aperture results in a central obscuration.

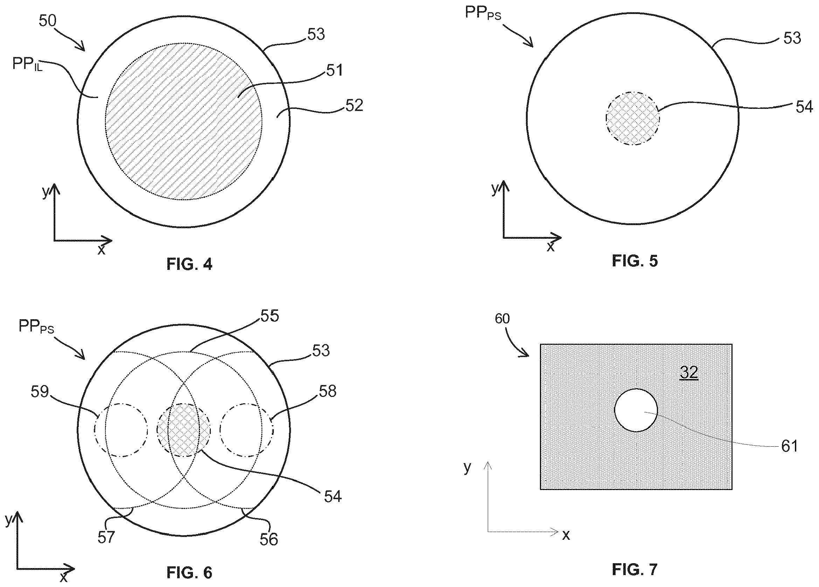

A general technique common to methods according to embodiments of the present invention is now described with reference to Figures 4 to 6.

Figure 4 is a schematic illustration of a conventional illumination mode 50 in the illumination system pupil plane PP_{IL} that it may be desired to measure. With this illumination mode 50, only a central portion 51 of the illumination system pupil plane PP_{IL} receives radiation whereas an outer portion 52 of the illumination system pupil plane PP_{IL} does not. Also shown is a circle 53 which represents the numerical aperture of the projection system PS. Figure 5 is a schematic representation of the projection system pupil plane PP_{PS} for a projection system PS having a central obscuration 54, representing a central portion of the projection system pupil plane PP_{PS} which does not receive radiation. Also shown is a circle 53 which represents the numerical aperture of the projection system PS.

Figure 6 is a schematic representation of the intensity of radiation in the projection system pupil plane PP_{PS} of Figure 5 when a diffraction grating 17 is illuminated by the illumination mode 50 shown in Figure 4.

As explained above, when a diffraction grating 17 is disposed in the object plane of the projection system PS the resultant diffraction will, in general, cause radiation from a given point in the illuminator pupil plane PP_{IL} to map into a plurality of points in the projection system pupil plane PP_{PS}. The zeroth order diffraction beam for the illumination mode 50 maps onto a conjugate region 55 of the projection system pupil plane PP_{PS}. This conjugate region 55 of the projection system pupil plane PP_{PS} overlaps with the central obscuration 54.

Higher order diffraction beams from the diffraction gratin 17 map onto different parts of the projection system pupil plane PP_{PS} or may fall outside of the numerical aperture of the projection system PS such that they do not contribute to the image formed in the image plane. Also shown in Figure 6 are a region 56 of the projection system pupil plane PP_{PS} which receives radiation from a +1^{st} order diffraction beam and a region 57 of the projection system pupil plane PP_{PS} which receives radiation from a -1^{st} order diffraction beam. Note that each of these regions 56, 57 includes a region 58, 59 respectively which receives radiation from a part of the illumination mode 50 that is conjugate to the central obscuration 54.

Therefore, methods according to embodiments of the present invention produce shifted copies 56, 57 of the object level pupil or illumination mode 50 in the projection system pupil plane PP_{PS}. This can allow parts of the object level pupil which correspond to (or are conjugate with) an obscuration 54 of the projection system pupil plane PP_{PS} to be shifted to regions 58, 59 of the projection system pupil plane PP_{PS} which do not overlap with the obscuration 54. As a result, these parts of the object level pupil 50 can be measured at image level.

A first embodiment of a method according to the present invention is now described with reference to Figures 7 to 10.

This embodiment uses two separate measurements which are then combined to determine the object level pupil or illumination mode 50. Although in the following description for clarity these will be referred to as a first measurement and a second measurement, it will be appreciated that the two measurements can be performed in any order.

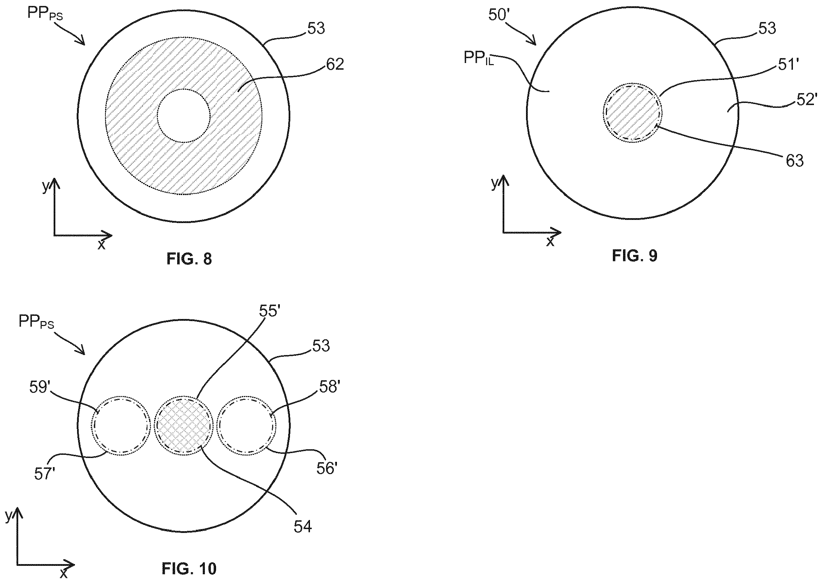

In a first measurement, the illumination system IL is used to project the radiation beam B into an object that samples at least a part of the radiation such at least that part of the radiation is received by the projection system PS with substantially the same angular distribution. Such an object 60 is shown in Figure 7, wherein the object 60 is of the form of a reflective pinhole. The object 60 comprises a circular region 61 of reflective material in the object plane that is surrounded by a radiation blocking region 32 that substantially blocks radiation received by it from entering the projection system PS. The circular region 61 and may have a diameter of the order of 50 µm. Figure 8 is a schematic representation of the intensity of radiation in the projection system pupil plane PP_{PS} of Figure 5 when the object 60 shown in Figure 7 is illuminated by the illumination mode 50 shown in Figure 4. As can be seen in Figure 8, only a region 62 of the projection system pupil plane PP_{PS} which corresponds to a part of the central portion 51 of the illumination system pupil plane PP_{IL} (see Figure 4) which does not overlap with the central obscuration 54 of the projection system PS (see Figure 5) receives radiation. It will be appreciated that this first measurement allows all parts of the illumination mode 50 to be determined except those parts that are conjugate to the obscuration 54.

In a second, separate measurement, a diffraction grating 17 is used, as described above, such that the parts of the illumination mode 50 that are conjugate to the obscuration 54 are mapped onto parts of the projection system pupil plane PP_{PS} outside of the obscuration 54. These parts of the illumination mode 50 are therefore sampled by the sensor apparatus 19 and can be determined during this second measurement.

In some embodiments, during this second measurement using the diffraction grating 17, only a part of the angular distribution or illumination mode 50 to be measured is used. In particular, it may be that the only a part of the angular distribution to be measured which substantially corresponds to, or is substantially conjugate to, the obscuration 54 is used. For example, as shown in Figure 9, a modified illumination mode 50' may be used.

The modified illumination mode 50' comprises a smaller central portion 51' of the illumination system pupil plane PP_{IL} which receives radiation and a larger outer portion 52' of the illumination system pupil plane PP_{IL} which does not. It will be appreciated that the intensity distribution within the central portion 51' is the same as that of the corresponding or conjugate portion of the central portion 51 of illumination mode 50 shown in Figure 4. Also shown is a circle 53 which represents the numerical aperture of the projection system PS and a circle 63 which represents the obscuration 54. It will be appreciated that the central portion 51' of the modified illumination mode 50' shown in Figure 9 preferably includes the entire circle 63 which represents the obscuration 54 and may also contain a little more of the central portion 51 of illumination mode 50 shown in Figure 4.

Figure 10 is a schematic representation of the intensity of radiation in the projection system pupil plane PP_{PS} of Figure 5 when a diffraction grating 17 is illuminated by the modified illumination mode 50' shown in Figure 9.

In a similar manner to Figure 6, Figure 10 shows: a region 55' which is conjugate to the modified illumination mode 50' and two regions 56', 57' of the projection system pupil plane PP_{PS} which receive radiation from the +1^{st} order diffraction beam and the -1^{st} order diffraction beam respectively. Also shown are regions 58', 59' within each of these regions 56', 57' which receive radiation from a part of the modified illumination mode 50' that is conjugate to the central obscuration 54.

As will be appreciated from a comparison of Figures 10 and 6, by using the modified illumination mode 50' shown in Figure 9, the overlap between adjacent diffraction orders can be reduced or even eliminated. Advantageously, it may be that the regions 58', 59' which receive radiation from a part of the modified illumination mode 50' that is conjugate to the central obscuration 54 do not overlap with any other contributions from the modified illumination mode 50'. If this is the case then either or both of the regions 58', 59' which receive radiation from a part of the modified illumination mode 50' that is conjugate to the central obscuration 54 can be used to directly determine the part of the illumination mode 50 that is conjugate to the obscuration 50. Here, it will be appreciated that any such determination will take into account the diffraction efficiencies for the +1^{st} order diffraction beam and the -1^{st} order diffraction beam respectively. In some embodiments, both of the regions 58', 59' which receive radiation from a part of the modified illumination mode 50' that is conjugate to the central obscuration 54 can be used to directly determine the part of the illumination mode 50 that is conjugate to the obscuration 50 and an average of these two determinations can be found.

As explained above, in addition to the circle 63 which represents the obscuration 54, the modified illumination mode 50' (which is used for the second measurement) may and may also contain a little more of the central portion 51 of illumination mode 50 shown in Figure 4 (see Figure 9). This ensures that there will be some overlap between the first and second measurements (the outer part of the pupil measured without diffraction and the inner part of the pupil measured with diffraction). Advantageously, by measuring slightly more of the pupil than the part that is conjugate to the obscuration 54 during the second measurement (for example using the modified illumination mode 51' shown in Figure 9), the intensities of the two separate measurements can be matched because certain parts of the pupil will be measured in both measurements.

It will be appreciated that, in pupil plane coordinates that are normalized to the numerical aperture NA of the projection system PS, the shift of each non-zeroth order diffraction beam from the zeroth order diffraction beam in the projection system pupil plane PP_{PS} is given by (n·λ)/(p·NA), where n is the diffraction order, λ is the wavelength of the radiation beam B and p is the pitch of the diffraction grating 17. It may be desirable to select a suitable pitch p of the diffraction grating 17, bearing in mind the wavelength λ of the radiation beam B and the numerical aperture NA of the projection system PS so that the regions 58', 59' which receive radiation from a part of the modified illumination mode 50' that is conjugate to the central obscuration 54 do not overlap with any other contributions from the modified illumination mode 50' and do not overlap with the central obscuration.

In some embodiments, the pitch p of the grating 17 is such that an angular separation of adjacent diffraction beams is greater than half an angular extent of the obscuration 54 of the projection system PS. Advantageously, with such an arrangement first order diffraction beams generated by the diffraction grating 17 will shift in the projection system pupil plane PP_{PS} relative to the zeroth order diffraction beam such that at least half of the portion of those diffraction beams which corresponds to, or is conjugate to, the obscuration 54 no longer overlaps with the obscuration 54 of the projection system PS. The ±1^{st} order diffraction beams will each be shifted in opposite directions (by at least half of the extent of the obscuration 54 of the projection system PS), potentially allowing both halves of the region of the object level pupil that corresponds to the obscuration 54 of the projection system PS to be determined (from the ±1^{st} order diffraction beams respectively). Even more preferably, the pitch p of the grating 17 is such that an angular separation of adjacent diffraction beams is greater than the entire angular extent of the obscuration 54 of the projection system PS. This allows the region of the object level pupil that corresponds to the obscuration 54 of the projection system PS to be determined from either one of the ±1^{st} order diffraction beams (or a combination of these, as discussed above).

In some embodiments, the pitch p of the grating 17 is such that an angular separation of adjacent diffraction beams is greater than an angular extent of the radiation that is projected onto the diffraction grating 17 in the object plane. That is, the pitch p of the grating 17 is sufficiently large (bearing in mind the angular extent of the modified illumination mode 50') that adjacent order diffraction beams generated by the diffraction grating 17 will not overlap in the projection system pupil plane PP_{PS}.

The first embodiment of a method according to the present invention (described above with reference to Figures 7 to 10) uses two separate measurements which are then combined to determine the object level pupil or illumination mode 50. In contrast, a second embodiment of a method according to the present invention may use a single measurement. In such a second embodiment, determining at least a part of the angular intensity distribution of radiation B at the object plane from the determined spatial intensity distribution of radiation 25 in the sensor plane 44 may comprise: associating at least one region of the spatial intensity distribution of radiation 25 in the sensor plane 44 with a weighted sum of a plurality of regions in the illumination system pupil plane PP_{IL}, the weights of said weighted sum being dependent on grating efficiencies of the grating 17. Each such region of the spatial intensity distribution of radiation 25 in the sensor plane 44 may correspond to a single sensing element or pixel in an array of sensing elements. For example, in one embodiment, when the radiation beam B is projected onto the diffraction grating 17 in the object plane so as to create at least one non-zeroth order diffraction beam which is at least partially received by the projection system PS substantially the entire angular distribution to be measured may be used. That is, an unmodified illumination mode 50 (as shown in Figure 4) may be used The grating 17 may create a plurality of copies of the object level pupil 50, the copies being shifted relative to each other in a shearing direction of the grating 17. These diffraction beams may partially overlap (see, for example, Figure 6). Therefore, at least some pixels in the sensor plane 44 may receive contributions from a plurality of different diffraction beams (and, therefore, from a plurality of different parts of the object level pupil 50 weighted by the corresponding grating efficiencies). It will be appreciated that this weighted sum may be an incoherent (intensity level) sum.

In some embodiments (with either the first or second embodiment of method discussed above) the diffraction grating 17 may be arranged to suppress the zeroth order diffraction beam. It will be appreciated that such suppression of the zeroth order diffraction beam may be achieved using phase-shift mask techniques. For example, the diffraction grating 17 may be of the form of an alternating phase-shift mask that is arranged such that alternate light transmitting portions (either transmissive or reflective) result in a 180° phase change for the zeroth order diffraction beam but not for non-zeroth order diffraction beams. For example, as previously explained, a diffraction grating 30 of the type shown in Figure 2 may be formed from a reflective substrate (for example a multi-layer stack or Bragg mirror) which provides the radiation reflecting portions 33, onto which the radiation absorbing portions 32, 34 are deposited. In some embodiments, alternate reflective portions 33 may be formed from different thicknesses of material so as to create a full optical path length difference for the zeroth order diffraction beam of λ/2.

Advantageously, this results in no zeroth order diffraction beam that may overlap with the non-zeroth order diffraction beams (for example the first order diffraction beams) in the projection system pupil plane PP_{PS}.

In some embodiments, the pitch p of the grating 17 is such that only the first order diffraction beams are at least partially received by the projection system PS. That is to say that the second order diffraction beams and higher order diffraction beams are not received by (i.e. fall outside the numerical aperture of) the projection system PS.

The novel methods and apparatus according to the present invention are advantageous since they allow for measurement of parts of the illumination pupil (at reticle level) that correspond to an obscuration of the projection system PS via a wafer level measurement. It will be appreciated that such parts of the illumination pupil can be of relevance to the imaging of substrates W since, as explained above, diffraction from a patterning device MA can cause these parts of the illumination pupil to be projected onto the substrate W. There are a number of lithographic processes for which it may be beneficial to use an illumination mode wherein a central portion of the illumination system pupil plane PP_{IL} is populated by the radiation, as now discussed.

One example is the imaging of a contact hole layer. Conducting contacts may be formed between structures of an integrated circuit that are formed in different layers of the integrated circuit. For example, it may be desirable to provide a conducting contact between a first structure in a first layer and a second structure in a second layer. Such structures may be formed by imaging a pattern of circular features in one or more layers that are intermediate the first and second layers in lithographic apparatus. These features may then be selectively etched away and the resultant contact hole can be filled with a conducting material. Imaging of a contact hole layer (i.e. a pattern of circular features) may be optimized by using an illumination mode wherein the intensity of radiation in the illumination system pupil plane PP_{IL} is non-zero in a central portion and, in addition, in multiple discrete peripheral portions of the pupil plane PP_{IL}.

In addition, a large conventional illumination mode may be used for imaging dense lines at multiple pitches and multiple orientations, but not at the resolution limit (i.e. for features with sufficiently large pitches). It will be appreciated here that a large conventional illumination mode is one for which the intensity of radiation is uniform within a central circular portion of the illumination system pupil plane PP_{IL}, the central circular portion comprising a large portion of the numerical aperture of the projection system PS (for example, as shown in Figure 4).

In general, using an illumination mode where there is significant overlap between the regions of the illumination system pupil plane PP_{IL} where the intensity of radiation is non-zero and an obscuration in the projection system PS can be beneficial. This is because this may ensure that the 0th order beam generated as the radiation is directed to a patterning device MA does not contribute significantly (or at all) to the imaging. In turn, this can be beneficial for the imaging because, for example, it can improve contrast and depth of focus for some structures (pitches), particularly when patterns having different pitches are imaged at the same time.

Although a single embodiment 30 of the (object-level) diffraction grating 17 is shown in Figure 2, it will be appreciated that in other embodiments the diffraction grating 17 may have other forms. For example, in general the diffraction grating 17 may have any form. For example, in an alternative embodiment the diffraction grating 17 may be a two-dimensional diffraction grating. For such embodiments, it will be appreciated that the diffraction grating will generate a two-dimensional array of diffraction beams (which may or may not partially overlap) and which are at least partially received by the projection system PS. Furthermore, the diffraction grating may have any orientation and any pitch (or pitches) as desired.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for determining at least a part of an angular intensity distribution of radiation at an object plane of an optical system, the method comprising:
directing the radiation onto a diffraction grating in the object plane so as to create at least one non-zeroth order diffraction beam which is at least partially received by the optical system;
forming an image of a pupil plane of the optical system in a sensor plane and determining a spatial intensity distribution of radiation in the sensor plane; and
determining at least a part of the angular intensity distribution of radiation at the object plane from the determined spatial intensity distribution of radiation in the sensor plane.

2. The method of claim 1 further comprising:
directing the radiation onto an object that samples at least a part of the radiation such that at least that part of the radiation is received by the optical system with substantially the same angular distribution;
forming an image of a pupil plane of the optical system in a sensor plane and determining a spatial intensity distribution of radiation in the sensor plane;
determining at least a part of the angular intensity distribution of radiation at the object plane from the determined spatial intensity distribution of radiation in the sensor plane.

3. The method of claim 2 wherein when the radiation is directed onto the diffraction grating in the object plane so as to create at least one non-zeroth order diffraction beam which is at least partially received by the optical system only a part of the angular distribution to be measured is used.

4. The method of claim 3 wherein the only a part of the angular distribution to be measured substantially corresponds to a part of a pupil plane of the optical system that is obscured by the optical system.

5. The method of any one of claims 2 to 4 wherein the pitch of the grating is such that an angular separation of adjacent diffraction beams is greater than half an angular extent of an obscuration of the optical system.

6. The method of any one of claims 2 to 5 wherein the pitch of the grating is such that an angular separation of adjacent diffraction beams is greater than an angular extent of the radiation that is directed onto the diffraction grating in the object plane.

7. The method of claim 1 wherein determining at least a part of the angular intensity distribution of radiation at the object plane from the determined spatial intensity distribution of radiation in the sensor plane comprises:
associating at least one region of the spatial intensity distribution of radiation in the sensor plane with a weighted sum of a plurality of regions in an object level pupil plane, the weights of said weighted sum of pixels being dependent on grating efficiencies of the grating.

8. The method of claim 7 wherein the pitch of the grating is such that an angular separation of adjacent diffraction beams is greater than half an angular extent of an obscuration of the optical system.

9. The method of any preceding claim wherein forming the image of the pupil plane of the optical system in the sensor plane and determining a spatial intensity distribution of radiation in the sensor plane comprises:
projecting the radiation onto a membrane having an aperture, the membrane being disposed in an image plane of the optical system; and
determining a spatial intensity distribution of radiation in a sensor plane on an opposite side of the membrane to the optical system.

10. The method of any preceding claim wherein the diffraction grating is provided on a region in the object plane that is surrounded by a radiation blocking region that substantially blocks radiation received by it from entering the optical system.

11. The method of claim 10 when dependent either directly or indirectly on claim 2 wherein the object that samples at least a part of the radiation such at least that part of the radiation is received by the optical system with substantially the same angular distribution is provided on a region in the object plane that is surrounded by a radiation blocking region that substantially blocks radiation received by it from entering the optical system.

12. The method of any preceding claim wherein the diffraction grating is arranged to suppress the zeroth order diffraction beam.

13. The method of any preceding claim wherein the pitch of the grating is such that only the first order diffraction beams are at least partially received by the optical system.

14. The method of any preceding claim wherein the pitch of the grating is such that second order diffraction beams and higher order diffraction beams are not received by the optical system.

15. An apparatus comprising:
an object support for supporting a patterning device in an object plane;
an image support for supporting a substrate in an image plane;
an illumination system operable to produce a radiation beam and irradiate the patterning device in the object plane so as to form a patterned radiation beam;
a projection system operable to receive the patterned radiation beam and to form an image of the patterning device in the image plane; and
a sensor, the sensor being operable to form an image of a pupil plane of the projection system in a sensor plane to and determine a spatial intensity distribution of radiation in the sensor plane; and
a processor operable to determine at least a part of the angular intensity distribution of the radiation beam at the object plane from the determined spatial intensity distribution of radiation in the sensor plane;
wherein the projection system has an obscuration such that an intensity of the patterned radiation beam in a part of the pupil plane of the projection system is substantially zero; and
wherein the at least a part of the angular intensity distribution of the radiation beam that the processor is operable to determine includes a part of the angular intensity distribution of the radiation beam that corresponds to the obscuration of the projection system.

16. The apparatus of claim 15 configured to perform the method of any one of claims 1 to 14.
